**Europäisches Patentamt**

**European Patent Office**

**Office européen des brevets**

(19)

(11) Publication number: **0 017 044**
**B1**

# (12) EUROPEAN PATENT SPECIFICATION

(45) Date of publication of patent specification: **03.07.85**

(51) Int. Cl.⁴: **G 03 B 41/00**

(21) Application number: **80101308.7**

(22) Date of filing: **13.03.80**

(54) A system for positioning a utilization device.

(30) Priority: **02.04.79 US 25917**

(43) Date of publication of application:
**15.10.80 Bulletin 80/21**

(45) Publication of the grant of the patent:
**03.07.85 Bulletin 85/27**

(84) Designated Contracting States:
**DE FR GB IT**

(56) References cited:
**FR-A-2 274 073**

(73) Proprietor: **EATON-OPTIMETRIX INC.**
**4001 North First Street**
**San Jose California 95134 (US)**

(72) Inventor: **Phillips, Edward H.**
**Post Office Box 1042**
**Middletown/California 95 461 (US)**

(74) Representative: **Liesegang, Roland, Dr.-Ing.**
**Sckellstrasse 1**
**D-8000 München 80 (DE)**

Courier Press, Leamington Spa, England.

## Description

The invention relates to a system for positioning a utilization device, which forms part of an optical imaging system, along an axis, said system including a base structure; a slide for supporting the utilization device; drive means for moving the slide relative to the base structure along said axis; and constraining means, including the drive means, for constraining the slide.

In the semiconductor industry, reduction lens systems are employed in the fabrication of photomasks to print an array of microcircuitry on each photomask. A set of such photomasks, each bearing an array of microcircuitry of a different level, is typically employed in the fabrication of integrated circuits from a semiconductive wafer. In the course of this fabrication, the semiconductive wafer is sequentially aligned with each photomask, and an exposure is made at each processing level to print the array of microcircuitry on the photomask onto the semiconductive wafer. Alternatively, similar reduction lens systems may be directly employed in an exposure operation to initially print each level of microcircuitry directly upon the semiconductive wafer rather than a photomask, thereby eliminating the photomask printing step entirely. However, whether a reduction lens system is employed to print a level of microcircuitry initially on a photomask or directly on a semiconductive wafer, the top surface of either the photomask or the wafer must be precisely focused, automatically, at the image plane of a projection lens of the lens system.

In a known system for positioning an optical imaging system of a microscope a drive means is a worm gear driven rack- and pinion-device which moves a focusing slide along a ball bearing guide ("Applied Optics and Optical Engineering", Ed. by R. Kingslake, Vol. IV, Optical Instruments, Chapter 2. Microscopes). In such a system the slide is typically under constrained so that, for example, correction of an out-of-focus condition of a wafer with respect to an imaging lens or the like may not be achieved with the required repeatability or precision.

It is therefore the main object of this invention to provide a system of the kind mentioned initially that may be employed for positioning a slide supporting a utilization device, that is capable of constraining movement of the slide in five degrees of freedom while permitting precise controlled movement of the slide in the sixth degree of freedom, and that may be ruggedly handled without damage.

This and other objects are accomplished by providing a system of the kind mentioned initially for positioning a utilization device, wherein the system is characterized according to the invention in that the center of gravity of the slide and the utilization device is disposed along a line spaced from the drive means, and in that the constraining means further includes five separate supports which together with the drive means are arranged between the base structure and the slide such that the weight of the slide and the utilization device loads each of the supports and the drive means, whereby the five loaded supports constrain, without overconstraining, the slide in five degrees.of freedom and the loaded drive means constrains the slide in a sixth degree of freedom to thereby kinematically constrain the slide in all six degrees of freedom.

When the system according to the invention is utilized as an optical focusing system, the utilization device comprises a kinematic lens positioning apparatus which may be kept virtually perturbation free in the directions in which the system is constrained.

Further features of the invention are specified in the subclaims.

The invention and its objects, effects and advantages are further illustrated by drawings of a preferred embodiment and the following detailed description.

Figure 1 is a right side view of an optical focusing system in accordance with the preferred embodiment of the present invention.

Figure 2 is a right side view of a kinematic lens positioning apparatus included in the system of Figure 1.

Figures 3A and 3B are front and right side views, respectively, illustrating the action of air bearings included in the apparatus of Figure 2.

Figure 4 is a graphic illustration of the directions in which the apparatus of Figure 2 is constrained from moving.

Figure 5 is an auxiliary view of a drive mechanism of the apparatus of Figure 2.

Figure 6 is a combined perspective view and schematic diagram of a distance measuring transducer or repositioning device utilized with the apparatus of Figure 2.

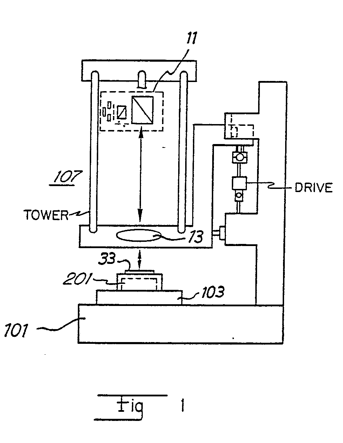

Referring now to Figure 1 of the drawings, there is shown an optical focusing system comprising a focus detection apparatus 11, a kinematic lens positioning apparatus 107 having a tower portion and a drive portion, and a kinematic wafer chuck differential leveling or positioning apparatus 201 (described in EP—A 0097380).

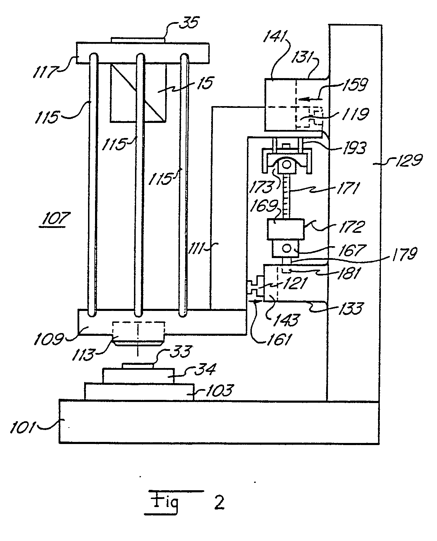

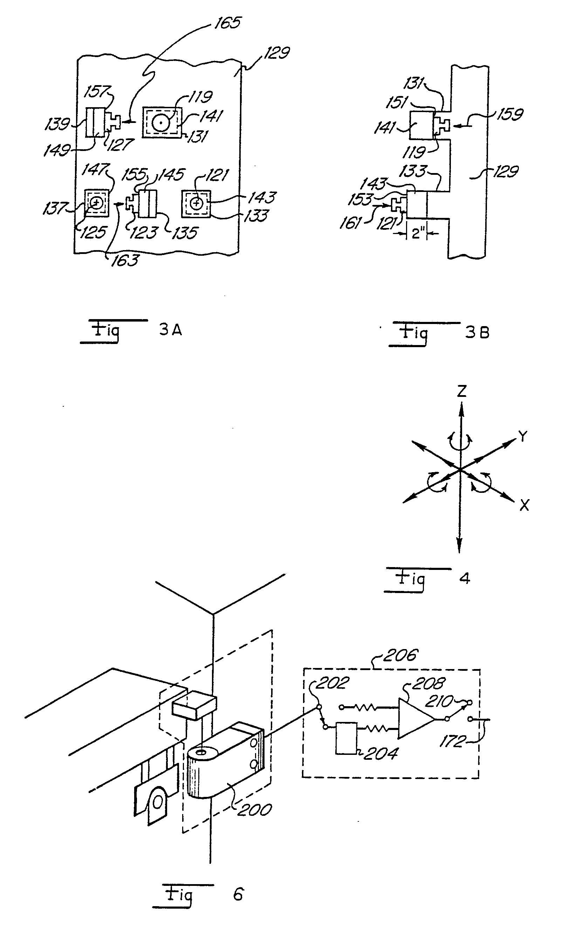

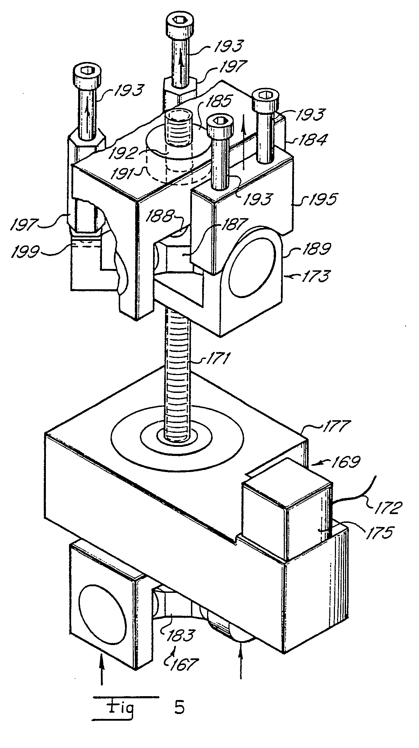

There is also shown a fixed granite block 101, a stage 103 and a chuck 34 supporting a wafer 33. As best shown in Figure 2 immediately above wafer 33 is supported the kinematic lens positioning apparatus 107 including a tower portion comprising a base 109, a vertical member 111 extending from the base, a projection lens enclosure 113 including the projection lens 13 (see Figure 1), and a set of six substantially vertical bars 115 (three being shown). Each of these bars has one end affixed (e.g., bolted) to the base 109 and the other end similarly affixed to a top member or reticle holder 117, which holder also supports beam splitter 15 and reticle 35. Also included in the tower portion of the kinematic lens positioning apparatus 107 are five air bearings 119, 121, 123, 125 and 127 disposed as shown in Figures 2, 3A and 3B for permitting vertical (translational) movement of the tower portion along the Z-axis only. Of the six degrees of freedom shown in Figure 4, translational movement along the X and Y axes and rotational movement about the X, Y and Z axes are constrained by the air bearings 119, 121, 123, 125 and 127 located as shown in Figures 2, 3A and 3B. Air bearings 119, 121 and 125 act to prevent translational movement along the Y axis and rotational movement about the X and Z axes, while air bearings 123 and 127 act to prevent translational movement along the X axis and rotational movement about the Y axis. Thus, only translational (vertical) movement along the Z axis is permitted.

As further shown in Figure 2, a cast iron casting 129 operates as a support structure for kinematic lens positioning apparatus 107. Casting 129, which, for example, weighs approximately 180 pounds, is rigidly affixed (by means of anchor bolts, not shown) to granite block 101 and extends vertically from the rear of granite block 101 parallel to the optical axis of lens positioning apparatus 107. Extending horizontally from the front of casting 129 (as best shown in Figures 3A and 3B) are five supports 131, 133, 135, 137 and 139 for five precision blocks 141, 143, 145, 147 and 149, which are lapped and adjusted (e.g., by means of an autocollimator) to have flat vertical faces on which the five air bearings may ride (e.g., air bearings 119, 121, 123 and 127 ride respectively on flat vertical faces 151, 153, 155 and 157). The weight of kinematic lens positioning apparatus 107 loads the air bearings with translational forces. As shown in Figures 2, 3A and 3B, a translational force is exerted on air bearing 119 in the direction indicated by arrow 159, a translational force is exerted on air bearings 121 and 125 in the direction indicated by arrow 161, a translational force is exerted on air bearing 123 in the direction indicated by arrow 163, and a translational force is exerted on air bearing 127 in the direction indicated by arrow 165.

As shown in Figures 2 and 5, kinematic lens positioning apparatus 107 also includes a drive portion comprising a first or lower universal joint assembly 167, servo motor drive and gear box assembly 169, a ball screw 171, and a second or upper universal joint assembly 173 upon which vertical member 111 of the tower portion of kinematic lens positioning apparatus 107 is supported for vertical movement of the tower portion with respect to casting 129. Motor drive and gear box assembly 169, which includes servo motor 175 and a gear box assembly 177, is mounted upon lower universal joint assembly 167. Actually, motor drive and gear box assembly 169 is mounted upon one leg (not shown) of lower universal joint assembly 167, with the other leg 179 being inserted into a hole 181 (Figure 2) of the casting 129 and affixed firmly to casting 129 as a support for motor drive and gear box assembly 169 and lower universal joint assembly 167. Within the lower universal joint assembly 167, however, the universal joint itself (i.e., universal joint 183 shown partly in Figure 5) is freely movable.

Servo motor 175 is coupled, via gear box assembly 177, to ball screw 171 for driving or applying a torque to the ball screw in response to receipt by the servo motor of a drive voltage (e.g., via lead 172) provided by a servo amplifier in response to a signal generated by focus detection apparatus 11. Ball screw 171 is coupled, via gear box assembly 177, to servo motor 175 and to lower universal joint assembly 167 and is freely swivelable with respect to the center of universal joint 183. Universal joint 183 acts to prevent gear box assembly 177 from rotating whenever a torque is applied by servo motor 175 to ball screw 171 via gear box assembly 177.

As shown in Figure 5, a second or upper universal joint assembly 173 comprises a ball nut retainer frame 184, a ball nut 185 screwed into retainer 184, a universal joint 187, and a tower lift bar 189. Except for having a hole 188 drilled through the center of universal joint 187 to permit passage of ball screw 171, the upper universal joint is identical to lower universal joint 183. Ball nut retainer 184 has a threaded hole 191 through which ball nut 185 is screwed. Ball nut 185, in turn, has a return ball track (not shown) through which balls circulate and a threaded hole 192 through which ball screw 171 is screwed. Ball nut 185 also has a threaded exterior for mating with threaded hole 191.

Spherical ended pins 197 and a V-block 195 are a part of the tower portion of kinematic lens positioning apparatus 107. As shown in Figures 2 and 5, spherical ended pins 197 and V-block 195 are affixed to vertical member 111 by bolts 193 and are supported by tower lift bar 189 for vertical movement therewith. In response to an amplified differential signal applied via lead 172 from the aforementioned amplifier, for example, servo motor 175 rotates ball screw 171, thereby driving ball nut 185 and ball nut retainer 184 and causing tower lift bar 189 and the tower portion (including pins 197 and V-block 195) to be moved vertically, the distance moved being in accordance with the magnitude of the differential signal and the direction of movement (up or down) being in accordance with the polarity of the differential signal.

On one side of tower lift bar 189, the tower portion is seated by means of V-block 195, and on two other sides of the tower lift bar (one side not shown), the tower portion is seated by means of pins 197 extending into V-grooves 199. This manner of seating permits easy removal and accurate replacement of the tower portion of kinematic lens positioning apparatus 107 from the drive portion of the apparatus. The height of the ball screw 171 and the length of the block surfaces upon which the air bearings 119, 121, 123, 125 and 127 (Figures 2, 3A and 3B) ride may be chosen to be any reasonable value (e.g., 3 inches) sufficient to permit easy removal or service of the stage or chuck without requiring removal of the projection lens.

Unlike prior-art systems, which utilize cables to move a projection lens assembly vertically and flexures to guide the assembly, kinematic lens positioning apparatus 107 utilizes rigid components such as ball screw 171, ball nut 185, double universal joints 183, 187 and five air bearings 119, 121, 123, 125 and 127 to provide freedom of movement in a selected direction (vertical) and yet not overconstrain the apparatus in other directions. As such, kinematic lens positioning apparatus 107 comprises a rugged, substantially non-sensitive apparatus (e.g., non-sensitive to environmental changes such as temperature, vibration, or impact).

To maintain the Z axis position of kinematic lens positioning apparatus 107 constant during periods of time when the optical focusing system is not controlling the focusing operation, a distance measuring transducer 200 may be utilized in conjunction with a control circuit 206, as shown in Figure 6. An output signal from transducer 200 is applied, via a switch 202, to a sample-and-hold circuit 204 each time kinematic lens positioning apparatus 107 is positioned in response to amplified differential signals received via lead 172 from the aforementioned amplifier. After kinematic lens positioning apparatus 107 is positioned, and lead 172 is disconnected from the aforementioned amplifier, switch 202 is switched, thereby connecting the output of distance measuring transducer 200 directly to an amplifier 208. Meanwhile, sample-and-hold circuit 204 holds the last voltage output received from transducer 200 before the switching of switch 202. Amplifier 208 acts as a comparator and amplifier and applies a drive voltage through a switch 210 (now closed) to lead 172, thereby maintaining kinematic lens positioning apparatus 107 in its position and maintaining the voltage from transducer 200 constant in closed loop fashion. Such a distance measuring transducer is commercially available as, for example, a Linear Variable Differential Transformer, Catalog Part No. 050H-DC from Schaevitz Engineering Corporation in Cambden, New Jersey.

The top surface of wafer 33 may in fact not be flat, but may be undulated or irregular. Therefore, as the wafer 33 is progressively positioned in different image positions under projection lens 13, the wafer surface will, in general, deviate from the image plane of the projection lens and will be out of focus. Thus, when a step-and-repeat exposure mode of operation is employed, kinematic lens positioning apparatus 107 will again respond to inputs (amplified differential signals) from the focus detection apparatus 11, and the tower and projection lens structure will track or follow the actual contour of the surface of wafer 33.

## Claims

1. A system for positioning a utilization device (11, 13, 113), which forms part of an optical imaging system, along an axis (Z), said system including a base structure (101, 129); a slide (111) for supporting the utilization device (11, 13, 113); drive means (169) for moving the slide (111) relative to the base structure (101, 129) along said axis (Z); and constraining means, including the drive means (169), for constraining the slide (111), characterized in that the center of gravity of the slide (111) and the utilization device (11, 13, 113) is disposed along a line spaced from the drive means (169), and in that the constraining means further includes five separate supports (119, 121, 123, 125, 127) which together with the drive means (169) are arranged between the base structure (101, 129) and the slide (111) such that the weight of the slide (111) and the utilization device (11, 13, 113) loads each of the supports and the drive means (169), whereby the five loaded supports (119, 121, 123, 125, 127) constrain without overconstraining the slide (111) in five degrees of freedom and the loaded drive means (169) constrains the slide (111) in a sixth degree of freedom to thereby kinematically constrain the slide (111) in all six degrees of freedom.

2. A system as claimed in claim 1, characterized in that said supports (119, 121, 123, 125, 127) comprise five air bearings.

3. A system as claimed in claim 1 or 2, characterized in that one of said slide (111) and said base structure (101, 129) includes two spherical ended pin members (197) and a V-block member (195) for engagement with a portion (189) of the drive means (169).

4. A system as claimed in claim 1, 2 or 3, characterized in that said drive means (169) includes first and second universal joints (183, 187), one of which is coupled to the base structure (101, 129) and the other of which is coupled to the slide (111).

5. A system as claimed in claim 4, characterized in that said drive means (169) further includes a drive motor gear unit (175, 177) coupled to the first universal joint (183); a nut (185) coupled to the second universal joint (187); and a lead screw (171) driven by the drive motor gear unit (175, 177) in engagement with the nut (185).

6. A system as claimed in claim 5, characterized in that said lead screw (171) is a ball screw; and said nut (185) is a ball nut.

7. A system as claimed in any of the preceding claims, characterized in that said utilization device (11, 13, 113) includes an imaging lens (13) and a focus detector (11) coupled to the drive means (169).

## Patentansprüche

1. System zum Positionieren einer Anwendungsvorrichtung (11, 13, 113) längs einer Achse (Z) wobei die Anwendungsvorrichtung Teil eines optischen Abbildungssystemes bildet, mit einer Basisstruktur (101, 129); einem Schlitten (111) zum Abstützen der Anwendungsvorrichtung (11, 13, 113); Antriebsmitteln (169) zum Bewegen des Schlittens (111) relativ zur Basisstruktur (101, 129) längs der Achse (Z) und Zwängungsmitteln einschließlich der Antriebsvorrichtung (169) zum Ausüben von Fesselkräften auf den Schlitten (111), dadurch gekennzeichnet, daß der Schwerpunkt des Schlittens (111) und der Anwendungsvorrichtung (11, 13, 113) längs einer von der Antriebsvorrichtung (169) einen Abstand aufweisenden Linie angeordnet ist und daß die Zwängungsmittel fünf getrennte Abstützungen (119, 121, 123, 125, 127) umfassen, welche zusammen mit der Antriebsvorrichtung (169) zwischen der Basisstruktur (101, 129) und dem Schlitten (111) so angeordnet sind, daß das Gewicht des Schlittens (111) und der Anwendungsvorrichtung (11, 13, 113) sämtliche Abstützungen und die Antriebsvorrichtung (169) belastet, wodurch die fünf belasteten Abstützungen (119, 121, 123, 125, 127) den Schlitten (111) in fünf Freiheitsgraden fesseln, ohne ihn zu verspannen, und die belastete Antriebsvorrichtung (169) den Schlitten (111) in einem sechsten Freiheitsgrad fesselt, um somit den Schlitten (111) in allen sechs Freiheitsgraden zu fesseln.

2. System nach Anspruch 1, dadurch gekennzeichnet, daß die Abstützungen (119, 121, 123, 125, 127) fünf Luftlager umfassen.

3. System nach Anspruch 1 oder 2, dadurch gekennzeichnet, daß der Schlitten (111) oder die Basisstruktur (101, 129) zwei sphärische Endstiftglieder (197) und ein V-Blockglied (195) zum Zusammenwirken mit einem Abschnitt (189) der Antriebsvorrichtung (169) aufweist.

4. System nach Anspruch 1, 2 oder 3, dadurch gekennzeichnet, daß die Antriebsvorrichtung (169) erste und zweite Universalgelenke (183, 187) aufweist, von denen das eine mit der Basisstruktur (101, 129) und das andere mit dem Schlitten (111) gekuppelt ist.

5. System nach Anspruch 4, dadurch gekennzeichnet, daß die Antriebsvorrichtung (169) ferner einen mit dem ersten Universalgelenk (183) gekuppelten Getriebemotor (175, 177), eine mit dem zweiten Universalgelenk (187) gekuppelte Mutter (185) und eine Leitschraubspindel (171) aufweist, die vom Getriebemotor (175, 177) angetrieben ist und mit der Mutter (185) zusammenwirkt.

6. System nach Anspruch 5, dadurch gekennzeichnet, daß die Leitschraubspindel (171) eine Kugelspindel ist und daß die Mutter (185) eine Kugelmutter ist.

7. System nach einem der vorangehenden Ansprüche, dadurch gekennzeichnet, daß die Anwendungsvorrichtung (11, 13, 113) eine Abbildungslinse (13) und einen mit der Antriebsvorrichtung (169) gekuppelten Fokus-Detektor (11) umfaßt.

**Revendications**

1. Un système pour positionner un appareil (11, 13, 113) qui fait partie d'un système optique de formation d'image, le long d'un axe (Z), ledit système comprenant une structure de base (101, 129); un coulisseau (111) pour supporter l'appareil (11, 13, 113); un moyen d'entraînement (168) pour déplacer le coulisseau (111) par rapport à la structure de base (101, 129) le long dudit axe (Z); et un moyen de maintien, comportant le moyen d'entraînement (169), pour maintenir le coulisseau (111), caractérisé en ce que le centre de gravité du coulisseau (111) et de l'appareil (11, 13, 113) est disposé le long d'une ligne espacée du moyen d'entraînement (169), et en ce que le moyen de maintien comprend en outre cinq supports séparés (119, 121, 123, 125, 127) qui sont disposés avec le moyen d'entraînement (169) entre la structure de base (101, 129) et le coulisseau (111) de telle sorte que le poids du coulisseau (111) et de l'appareil (11, 13, 113) charge chacun des supports et le moyen d'entraînement (169), les cinq supports chargés (119, 121, 123, 125, 127) maintenant ainsi, sans excès de maintien, le coulisseau (111) dans cinq degrés de liberté et le moyen d'entraînement chargé (169) maintenant le coulisseau (111) dans un sixième degré de liberté afin qu'ainsi le coulisseau (111) soit maintenu cinématiquement dans tous les six degrés de liberté.

2. Un système comme revendiqué dans la revendication 1, caractérisé en ce que lesdits supports (119, 121, 123, 125, 127) comprennent cinq paliers pneumatiques.

3. Un système comme revendiqué dans la revendication 1 ou 2, caractérisé en ce que l'un dudit coulisseau (111) et de ladite structure de base (101, 129) comprend deux broches à extrémités sphériques (197) et un bloc en forme de V (195) entrant en contact avec une partie (189) du moyen d'entraînement (169).

4. Un système comme revendiqué dans la revendication 1, 2 ou 3, caractérisé en ce que ledit moyen d'entraînement (169) comprend un premier et un second joint universel (183, 187), dont l'un est accouplé à la structure de base (101, 129) et l'autre est accouplé au coulisseau (111).

5. Un système comme revendiqué dans la revendication 4, caractérisé en ce que ledit moyen d'entraînement (169) comprend en outre un ensemble à moteur et mécanisme de transmission (175, 177) accouplé au premier joint universel (183); un écrou (185) accouplé au second joint universel (187); et une vis-mère (171) entraînée par l'ensemble à moteur et mécanisme de transmission (175, 177) en prise avec l'écrou (185).

6. Un système comme revendiqué dans la revendication 5, caractérisé en ce que ladite vis-mère (171) est une vis à billes et en ce que ledit écrou (185) est un écrou à billes.

7. Un système comme revendiqué dans une quelconque des revendications précédentes, caractérisé en ce que ledit appareil (11, 13, 113) comprend une lentille de formation d'image (13) et un détecteur de foyer (11) accouplé au moyen d'entraînement (169).

Fig 1

0 017 044

Fig 2

2

Fig 3A

Fig 3B

Fig 4

Fig 6

Fig 5